(19) Europäisches Patentamt
European Patent Office
Office européen des brevets

(11) **EP 3 592 113 B1**

(12) **FASCICULE DE BREVET EUROPEEN**

(45) Date de publication et mention
de la délivrance du brevet:
**15.06.2022 Bulletin 2022/24**

(21) Numéro de dépôt: **19182610.6**

(22) Date de dépôt: **26.06.2019**

(51) Classification Internationale des Brevets (IPC):
**H05B 45/50** *(2022.01)* **H05B 45/37** *(2020.01)*

(52) Classification Coopérative des Brevets (CPC):
**H05B 45/50; H01L 31/02019; H05B 45/37;
H05B 45/60**

(54) **SYSTÈME DE PILOTAGE DE L'ALIMENTATION ÉLECTRIQUE D'UNE SOURCE LUMINEUSE PIXELLISÉE**

SYSTEM ZUR STEUERUNG DER STROMVERSORGUNG FÜR EINE VERPIXELTE LICHTQUELLE

SYSTEM FOR CONTROLLING THE ELECTRIC POWER SUPPLY OF A PIXELLATED LIGHT SOURCE

(84) Etats contractants désignés:
**AL AT BE BG CH CY CZ DE DK EE ES FI FR GB
GR HR HU IE IS IT LI LT LU LV MC MK MT NL NO
PL PT RO RS SE SI SK SM TR**

(30) Priorité: **28.06.2018 FR 1855882**

(43) Date de publication de la demande:
**08.01.2020 Bulletin 2020/02**

(73) Titulaire: **Valeo Vision
93012 Bobigny Cedex (FR)**

(72) Inventeurs:
• **KRICK, Sebastian
93012 BOBIGNY Cedex (FR)**
• **XIE, Qingyuan
93012 BOBIGNY Cedex (FR)**

(74) Mandataire: **Valeo Visibility
Service Propriété Industrielle
c/o Valeo Vision
34, rue Saint André
93012 Bobigny (FR)**

(56) Documents cités:
CA-A1- 2 792 187        DE-A1-102015 213 291
US-A1- 2004 207 532     US-A1- 2015 108 908
US-A1- 2016 143 101     US-A1- 2017 150 564
US-A1- 2018 070 416

**Description**

L'invention se rapporte au domaine de l'alimentation électrique de sources lumineuse pixellisées.

En particulier, l'invention se rapporte à un module lumineux comprenant un dispositif de pilotage de l'alimentation électrique et de gestion thermique de sources lumineuses, plus précisément de diodes électroluminescentes, LED, ou diodes électroluminescentes organiques, OLED, pixellisées ou segmentés. L'invention concerne également un dispositif pour un véhicule automobile.

Une diode électroluminescente, LED, est un composant électronique capable d'émettre de la lumière lorsqu'il est parcouru par un courant électrique. L'intensité lumineuse émise par une LED est en général dépendante de l'intensité du courant électrique qui la traverse. Entre autres, une LED est caractérisée par une valeur seuil d'intensité de courant. La valeur seuil de l'intensité de ce courant direct (« forward current ») est en général décroissante à température croissante. De même, lorsqu'une LED émet de la lumière, on observe à ses bornes une chute de tension égale à sa tension directe (« forward voltage »). Dans le domaine automobile, on a de plus en plus recours à la technologie LED ou OLED pour diverses solutions de signalisation lumineuse. Les LEDs sont utilisées afin d'assurer des fonctions lumineuses telles que les feux diurnes, les feux de signalisation, etc... Elles sont exposées à des températures de fonctionnement importantes.

L'utilité de matrices de LEDs, ou sources lumineuses pixellisées, comprenant un nombre important de sources lumineuses électroluminescentes élémentaires est intéressant dans de nombreux domaines d'application, et notamment dans le domaine d'éclairage et de la signalisation des véhicules automobiles. Une matrice de LEDs peut par exemple être utilisée pour créer des formes de faisceaux lumineux intéressantes pour des fonctions lumineuses telles que les feux de route ou les feux diurnes. En plus, plusieurs fonctions lumineuses différentes peuvent être réalisées à l'aide d'une matrice unique, réduisant ainsi l'encombrement physique dans l'espace restreint d'un feu de véhicule automobile. Une telle matrice comprend un montage de plusieurs branches parallèles, et chaque branche comprend un nombre important de sources lumineuses électroluminescentes branchées en série. Une telle source lumineuse pixellisée est typiquement alimentée en électricité par une source de tension, et chaque source élémentaire est associée à une source de courant linéaire afin de garantir une luminosité homogène. Comme un nombre important de sources lumineuses élémentaires est regroupé sur une surface très restreinte, le problème thermique est d'autant plus important et il devient important de contrôler la source de tension de manière précise et dynamique.

Il est connu d'utiliser un circuit de pilotage pour piloter l'alimentation d'un ensemble ou groupe de LEDs. Un tel circuit fait recours à un convertisseur DC/DC pour convertir une tension continue fournie par exemple par une batterie de voiture en une tension continue de charge, dépendante du nombre de LEDs alimentées. Cependant, pour des convertisseurs DC/DC à valeur de tension de sortie cible fixe, qui sont peu onéreux et par conséquent utilisés dans beaucoup d'application, la gestion thermique des LEDs est problématique. US2016/143101 A1 divulgue un module lumineux comprenant une source lumineuse pixelisée ainsi qu'un dispositif de pilotage de l'alimentation électrique d'une source lumineuse avec compensation en température. US2004/207532 A1 divulgue un feu d'avertissement avec compensation en température.

L'invention a pour objectif de pallier à au moins un des problèmes posés par l'art antérieur. Plus précisément, l'invention a pour objectif de proposer un module lumineux comprenant un dispositif de pilotage de l'alimentation électrique d'une source lumineuse pixellisée. Selon l'invention, dans la revendication 1 un module lumineux pour véhicule automobile comprenant une source lumineuse pixellisée et un dispositif de pilotage de l'alimentation électrique de ladite source lumineuse pixellisée est proposé. Le dispositif comprend :

-    un convertisseur destiné à convertir une tension électrique d'entrée en une tension électrique de charge à fournir à la source lumineuse pixellisée ;
-    des moyens d'asservissement du convertisseur, les moyens d'asservissement ayant en entrée une valeur représentative de l'intensité du courant électrique circulant dans la source lumineuse pixellisée.

Le dispositif est remarquable en ce qu'il comprend un élément microcontrôleur agencé pour générer un signal de contrôle, dont au moins une caractéristique dépend d'au moins un paramètre de la source lumineuse pixellisée, et pour injecter ce signal dans les moyens d'asservissement.

Les moyens d'asservissement comprennent un diviseur de tension agencé de façon à ce que la tension de charge soit une fonction de l'intensité du courant électrique circulant dans les moyens d'asservissement.

L'au moins un paramètre de la source lumineuse pixellisé p comprend une indication de la température de jonction de la source lumineuse pixellisée. L'indication de la température de jonction de la source lumineuse pixellisée peut de préférence être obtenue par lecture de la chute de tension aux bornes d'un composant thermistor placé à proximité de source lumineuse pixellisée, dont la résistance dépend de sa température,

De manière préférée, l'élément microcontrôleur peut être agencé pour générer un premier signal de type modulation de largeur d'impulsion, PWM, dont le rapport cyclique dépend dudit paramètre et dont une valeur moyenne correspond audit signal de contrôle.

L'amplitude du premier signal peut préférentiellement être est adaptée à une valeur de tension prédéfinie en utilisant un circuit d'adaptation de tension.

De préférence, le premier signal est relié à une montage filtre passe-bas afin de générer ledit signal de contrôle.

De préférence, la source lumineuse pixellisée peut comprendre une matrice d'éléments électroluminescent monolithique, ou une source lumineuse organique, OLED, segmentée.

Un dispositif de pilotage du courant électrique indépendant peut préférentiellement être agencé entre le dispositif de pilotage et la source lumineuse pixellisée.

De préférence, au moins une source de courant linéaire peut être intégrée au substrat de ladite source lumineuse.

La source lumineuse pixélisée peut de préférence comprend au moins une matrice d'éléments électroluminescents (appelée en anglais monolithic array) agencés selon au moins deux colonnes par au moins deux lignes. De préférence, la source électroluminescente comprend au moins une matrice d'éléments électroluminescents monolithique, aussi appelée matrice monolithique.

Dans une matrice monolithique, les éléments électroluminescents sont crûs depuis un substrat commun et sont connectés électriquement de manière à être activables sélectivement, individuellement ou par sous-ensemble d'éléments électroluminescents. Ainsi chaque élément électroluminescent ou groupe d'éléments électroluminescents peut former l'un des émetteurs élémentaires de ladite source lumineuse pixélisée qui peut émettre de la lumière lorsque son ou leur matériau est alimenté en électricité

Différents agencements d'éléments électroluminescents peuvent répondre à cette définition de matrice monolithique, dès lors que les éléments électroluminescents présentent l'une de leurs dimensions principales d'allongement sensiblement perpendiculaire à un substrat commun et que l'écartement entre les émetteurs élémentaires, formés par un ou plusieurs éléments électroluminescents regroupés ensemble électriquement, est faible en comparaison des écartements imposés dans des agencements connus de chips carrés plates soudés sur une carte de circuits imprimés.

Le substrat peut être majoritairement en matériau semi-conducteur. Le substrat peut comporter un ou plusieurs autres matériaux, par exemple non semi-conducteurs. Ces éléments électroluminescents, de dimensions submillimétriques, sont par exemple agencés en saillie du substrat de manière à former des bâtonnets de section hexagonale. Les bâtonnets électroluminescents prennent naissance sur une première face d'un substrat. Chaque bâtonnet électroluminescent, ici formé par utilisation de nitrure de gallium (GaN), s'étend perpendiculairement, ou sensiblement perpendiculairement, en saillie du substrat, ici réalisé à base de silicium, d'autres matériaux comme du carbure de silicium pouvant être utilisés sans sortir du contexte de l'invention. A titre d'exemple, les bâtonnets électroluminescents pourraient être réalisés à partir d'un alliage de nitrure d'aluminium et de nitrure de gallium (AlGaN), ou à partir d'un alliage de phosphures d'aluminium, d'indium et de gallium (AlInGaP). Chaque bâtonnet électroluminescent s'étend selon un axe d'allongement définissant sa hauteur, la base de chaque bâtonnet étant disposée dans un plan de la face supérieure du substrat.

Les bâtonnets électroluminescents d'une même matrice monolithique présentent avantageusement la même forme et les mêmes dimensions. Ils sont chacun délimités par une face terminale et par une paroi circonférentielle qui s'étend le long de l'axe d'allongement du bâtonnet. Lorsque les bâtonnets électroluminescents sont dopés et font l'objet d'une polarisation, la lumière résultante en sortie de la source à semi-conducteurs est émise essentiellement à partir de la paroi circonférentielle, étant entendu que des rayons lumineux peuvent sortir également de la face terminale. Il en résulte que chaque bâtonnet électroluminescent agit comme une unique diode électroluminescente et que la luminance de cette source est améliorée d'une part par la densité des bâtonnets électroluminescents présents et d'autre part par la taille de la surface éclairante définie par la paroi circonférentielle et qui s'étend donc sur tout le pourtour, et toute la hauteur, du bâtonnet. La hauteur d'un bâtonnet peut être comprise entre 2 et 10 $\mu$m, préférentiellement 8 $\mu$m; la plus grande dimension de la face terminale d'un bâtonnet est inférieure à 2 $\mu$m, préférentiellement inférieure ou égale à 1 $\mu$m.

On comprend que, lors de la formation des bâtonnets électroluminescents, la hauteur peut être modifiée d'une zone de la source lumineuse pixélisée à l'autre, de manière à accroitre la luminance de la zone correspondante lorsque la hauteur moyenne des bâtonnets la constituant est augmentée. Ainsi, un groupe de bâtonnets électroluminescents peut avoir une hauteur, ou des hauteurs, différentes d'un autre groupe de bâtonnets électroluminescents, ces deux groupes étant constitutifs de la même source lumineuse à semi-conducteur comprenant des bâtonnets électroluminescents de dimensions submillimétriques. La forme des bâtonnets électroluminescents peut également varier d'une matrice monolithique à l'autre, notamment sur la section des bâtonnets et sur la forme de la face terminale. Les bâtonnets présentent une forme générale cylindrique, et ils peuvent notamment présenter une forme de section polygonale, et plus particulièrement hexagonale. On comprend qu'il importe que de la lumière puisse être émise à travers la paroi circonférentielle, que celle-ci présente une forme polygonale ou circulaire.

Par ailleurs, la face terminale peut présenter une forme sensiblement plane et perpendiculaire à la paroi circonférentielle, de sorte qu'elle s'étend sensiblement parallèlement à la face supérieure du substrat, ou bien elle peut présenter une forme bombée ou en pointe en son centre, de manière à multiplier les directions d'émission de la lumière sortant de cette face terminale.

Les bâtonnets électroluminescents peuvent de préférence être agencés en matrice à deux dimensions. Cet agencement pourrait être tel que les bâtonnets soient agencés en quinconce. De manière générale, les bâtonnets sont disposés à intervalles réguliers sur le substrat et la distance de séparation de deux bâtonnets électroluminescents immédiatement adjacents, dans chacune des dimensions de la matrice, doit être au minimum égale à 2 $\mu$m, préférentiellement compris entre 3 $\mu$m et 10 $\mu$m, afin que la lumière émise par la paroi circonférentielle de chaque bâtonnet puisse sortir de la matrice de bâtonnets électroluminescents. Par ailleurs, on prévoit que ces distances de séparation, mesurées entre deux axes d'allongement de bâtonnets adjacents, ne soient pas supérieures à 100 $\mu$m.

Alternativement, la matrice monolithique peut comporter des éléments électroluminescents formés par des couches d'éléments électroluminescents épitaxiées, notamment une première couche en GaN dopée n et une seconde couche en GaN dopée p, sur un substrat unique, par exemple en carbure de silicium, et que l'on découpe (par meulage et/ou ablation) pour former une pluralité d'émetteurs élémentaires respectivement issus d'un même substrat. Il résulte d'une telle conception une pluralité de blocs électroluminescents tous issus d'un même substrat et connectés électriquement pour être activables sélectivement les uns des autres.

Dans un exemple de réalisation selon cet autre mode, le substrat de la matrice monolithique peut présenter une épaisseur comprise entre 100 $\mu$m et 800 $\mu$m, notamment égale à 200 $\mu$m ; chaque bloc peut présenter une largeur et largeur, chacune étant comprise entre 50 $\mu$m et 500 $\mu$m, préférentiellement comprise entre 100 $\mu$m et 200 $\mu$m. Dans une variante, la longueur et la largeur sont égales. La hauteur de chaque bloc est inférieure à 500 $\mu$m, préférentiellement inférieur à 300 $\mu$m. Enfin la surface de sortie de chaque bloc peut être faite via le substrat du côté opposée à l'épitaxie. La distance de séparation entre deux émetteurs élémentaires. La distance entre chaque émetteur élémentaire contigu peut être inférieure à 1 $\mu$m, notamment inférieure à 500 $\mu$m, et elle est préférentiellement inférieure à 200 $\mu$m.

Alternativement, aussi bien avec des bâtonnets électroluminescents s'étendant respectivement en saillie d'un même substrat, tels que décrit ci-dessus, qu'avec des blocs électroluminescents obtenus par découpage de couches électroluminescentes superposées sur un même substrat, la matrice monolithique peut comporter en outre une couche d'un matériau polymère dans laquelle les éléments électroluminescents sont au moins partiellement noyés. La couche peut ainsi s'étendre sur toute l'étendue du substrat ou seulement autour d'un groupe déterminé d'éléments électroluminescents. Le matériau polymère, qui peut notamment être à base de silicone, crée une couche protectrice qui permet de protéger les éléments électroluminescents sans gêner la diffusion des rayons lumineux. En outre, il est possible d'intégrer dans cette couche de matériau polymère des moyens de conversion de longueur d'onde, et par exemple des luminophores, aptes à absorber au moins une partie des rayons émis par l'un des éléments et à convertir au moins une partie de ladite lumière d'excitation absorbée en une lumière d'émission ayant une longueur d'onde différente de celle de la lumière d'excitation. On pourra prévoir indifféremment que les luminophores sont noyés dans la masse du matériau polymère, ou bien qu'ils sont disposés en surface de la couche de ce matériau polymère.

La source lumineuse pixélisée peut comporter en outre un revêtement de matériau réfléchissant pour dévier les rayons lumineux vers les surfaces de sorties de la source lumineuse.

Les éléments électroluminescents de dimensions submillimétriques définissent dans un plan, sensiblement parallèle au substrat, une surface de sortie déterminée. On comprend que la forme de cette surface de sortie est définie en fonction du nombre et de l'agencement des éléments électroluminescents qui la composent. On peut ainsi définir une forme sensiblement rectangulaire de la surface d'émission, étant entendu que celle-ci peut varier et prendre n'importe quelle forme sans sortir du contexte de l'invention.

En utilisant les mesures proposées par les modes de réalisation de la présente invention, il devient possible de contrôler de manière précise et dynamique le niveau de tension de sortie d'un convertisseur à boucle d'asservissement, afin de l'adapter aux besoins requis par une source lumineuse pixélisée alimentée par le convertisseur. Le signal de contrôle est généré par un élément microcontrôleur qui l'injecte dans la boucle d'asservissement. En passant par un signal de modulation de largeur d'impulsion, une valeur discrète précise peut être générée, en adaptant l'amplitude des impulsions du signal ainsi que son rapport cyclique au sein de l'élément microcontrôleur. Le signal de contrôle peut en outre dépendre de n'importe que quel paramètre de la source lumineuse. Ce paramètre est la température de la source lumineuse pixélisée, ce qui permet au dispositif selon l'invention d'implémenter une gestion thermique efficace de la source lumineuse en question.

D'autres caractéristiques et avantages de la présente invention seront mieux compris à l'aide de la description des exemples et des dessins parmi lesquels :

- la figure 1 montre une vue schématisée d'un dispositif de pilotage selon un mode réalisation préféré de l'invention ;
- la figure 2 montre une vue schématisée d'un dispositif de pilotage selon un mode réalisation préféré de l'invention ;
- la figure 3 montre une vue schématisée d'un détail d'un dispositif de pilotage selon un mode réalisation préféré de l'invention.

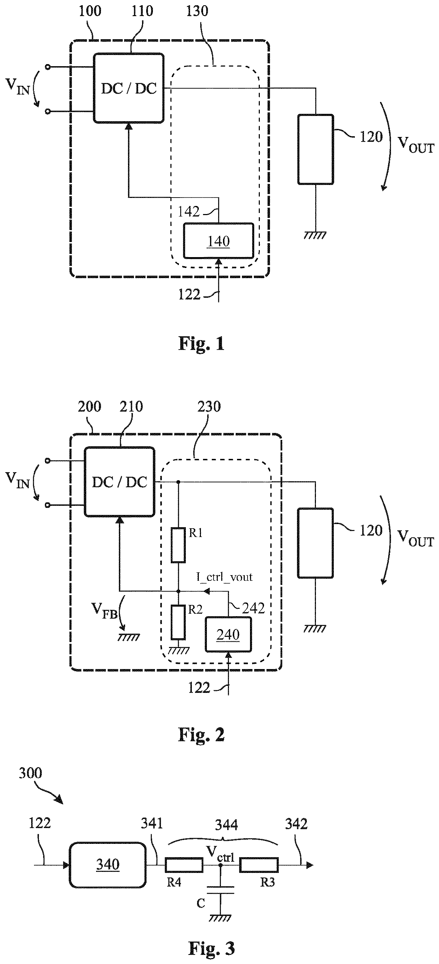

Des numéros de référence similaires seront utilisés pour décrire des concepts semblables à travers différents modes de réalisation de l'invention. Par exemple, les références 100, 200 et 300 désignent trois modes de réalisation d'un dispositif de pilotage conforme à l'invention. L'illustration de la figure 1 montre de manière schématique un dispositif 100 de pilotage de l'alimentation électrique selon un mode de réalisation de l'invention. Le convertisseur 110, qui peut être un convertisseur de type abaisseur de tension (« buck »), ou élévateur de tension (« boost »), ou une combinaison de convertisseurs buck et boost, est capable de convertir une tension continue d'entrée Vin, fournie par une source non-illustrée, en une tension continue de sortie Vout. La tension de sortie alimente une source lumineuse pixellisée 120. La source lumineuse peut par exemple comprendre une matrice d'éléments électroluminescents monolithiques, ou une source lumineuse organique, OLED, a plusieurs segments. Il est connu d'asservir un convertisseur 110 en courant, de façon à adapter le niveau de tension fournie au circuit monté en charge.

Selon l'invention les moyens d'asservissement 130 comprennent un élément microcontrôleur 140, qui prend en entrée un paramètre 122 de la source lumineuse pixellisée 120. Afin de donner un exemple concret mais sans pour autant limiter l'invention à cet exemple, il peut s'agir de la température de la source lumineuse pixellisée 122. En sortie, l'élément microcontrôleur génère un signal de contrôle 142, dépendant du paramètre 122, qui est injecté dans la boucle d'asservissement 130 du convertisseur 110. Ainsi, l'élément microcontrôleur est capable d'agir de manière précise et dynamique sur le niveau de tension Vout fourni par le convertisseur 110, en fonction d'un paramètre de la source lumineuse pixellisée alimentée. Dans le cas de la température, l'élément microcontrôleur implémente une gestion thermique de la source lumineuse pixellisée, en agissant sur la tension d'alimentation en fonction de la température de la source lumineuse. A cet effet, l'élément microcontrôleur comprend par exemple une mémoire dans laquelle les caractéristiques thermiques et le comportement y associé de la source lumineuse sont pré-enregistrées. En se référant à ces données, le signal de contrôle 142 est choisi de manière à adapter la tension Vout à la température 122.

L'illustration de la figure 2 reprend l'architecture générale du mode de réalisation précédant. La boucle d'asservissement 230 comprend en outre un pont diviseur de tension réalisé par le montage des résistances R1 et R2 respectivement. La tension VFB appliqué à la borne d'asservissement du convertisseur 210 est reliée à la tension de sortie Vout de la manière suivante : $Vout = VFB \times \left(1 + \frac{R1}{R2}\right) - I\_ctrl\_vout \times R1$. Il devient clair qu'en introduisant, moyennant le signal de contrôle 242 issu de l'élément microcontrôleur 240, un biais dans le courant I_ctrl_vout, la valeur de la tension Vout peut être directement impactée.

L'illustration de la figure 3 montre un mode de réalisation préféré de la génération du signal de contrôle 342. Par rapport au schéma de montage de la figure 2, l'élément microcontrôleur 240 est à remplacer par l'élément microcontrôleur 340 et le montage 344. L'élément microcontrôleur prend en entrée un paramètre 122 de la source lumineuse pixellisée et détermine, comme décrit plus haut, une valeur de biais correspondante à injecter dans la boucle d'asservissement du convertisseur.

Afin de générer ce signal de contrôle 342 correspondant à la valeur de biais sélectionnée de manière précise, l'élément microcontrôleur génère dans un premier temps un premier signal 341 de type modulation de largeur d'impulsion, PWM (« pulse width modulation »). Ce signal périodique discret se caractérise principalement par son rapport cyclique, i.e. le rapport entre la durée d'une impulsion et la durée totale d'une période du signal. Un rapport cyclique de 50% d'un signal PWM à impulsion unitaire génère un signal ayant une valeur moyenne de 0.5 V.

L'élément microcontrôleur est adapté à déterminer le rapport cyclique de manière précise, ce qui permet de générer un signal PWM ayant une valeur moyenne précisément définie entre 0 et 1V. Il est connu de faire varier un tel signal unitaire à des impulsion de tensions plus élevées. De cette façon, un signal PWM 341 ayant une moyenne comprise entre 0 et par exemple 5V peut être précisément généré par l'élément microcontrôleur. En passant le signal 342 ainsi généré par un montage filtre passe-bas 344, réalisé par exemple par le circuit RC comprenant les résistances R3, R3 et la capacité C, le signal de contrôle 342 correspond de manière précise à la composante continue, i.e., la moyenne du signal PWM 341 initial. De manière formelle, la tension Vctrl indiquée sur la figure 3 est donnée par :

$$Vctrl = \frac{R4 \times VFB + R3 \times V_{PWM_{average}}}{R3 + R4}$$

, ou VPWM average désigne la valeur moyenne du signal PWM 341. En choisissant R3>>R4, ceci se réduit à :

$$Vctrl \approx V_{PWM_{average}} + \frac{R4}{R3} \times VFB \approx V_{PWM_{average}}.$$

Il faut remarquer que le courant électrique I_ctrl_Vout circulant dans la boucle d'asservissement est donné par

$$I\_ctrl\_vout = \frac{Vctrl - VFB}{R3}$$

. A titre d'exemple, si VFB=0.8V, R3=40kΩ, R4 = 10kΩ et C=10μF, une variation de 1V au niveau du signal de contrôle 342, qui peut être déterminée de manière précise, par exemple on utilisant un signal PWM à 1kHz et 1% de rapport cyclique, implique une variation de 0.1 V au niveau de la tension de charge Vout fournie par le convertisseur 110.

L'étendue de la protection est définie par les revendications suivantes.

## Revendications

1. Module lumineux pour un véhicule automobile comprenant une source lumineuse pixellisée (120) et un dispositif de pilotage de l'alimentation électrique (100, 200, 300) de ladite source lumineuse pixellisée, le dispositif de pilotage de l'alimentation électrique (100, 200, 300) comprenant :

   - un convertisseur (110, 210) destiné à convertir une tension électrique d'entrée en une tension électrique de charge à fournir à la source lumineuse pixellisée ;
   - des moyens d'asservissement (130, 230) du convertisseur, les moyens d'asservissement ayant en entrée une valeur représentative de l'intensité du courant électrique circulant dans la source lumineuse pixellisée,
   - un élément microcontrôleur (140, 240, 340) agencé pour générer un signal de contrôle (142, 242, 342), dont au moins une caractéristique dépend d'au moins un paramètre (122) de la source lumineuse pixellisée (120), et pour injecter le signal de contrôle dans les moyens d'asservissement, l'au moins paramètre (122) de la source lumineuse pixellisé comprenant une indication de la température de jonction de la source lumineuse pixellisée,

   le module lumineux étant **caractérisé en ce que** les moyens d'asservissement (230) comprennent un diviseur de tension recevant le signal de contrôle de l'élément microcontrôleur de façon à ce que la tension de charge soit une fonction de l'intensité du courant électrique circulant dans les moyens d'asservissement.

2. Module lumineux selon la revendication 1 dans lequel l'élément microcontrôleur (340) est agencé pour générer un premier signal (341) de type modulation de largeur d'impulsion, PWM, dont le rapport cyclique dépend dudit au moins un paramètre (122) et dont une valeur moyenne correspond audit signal de contrôle (342).

3. Module lumineux selon la revendication précédente dans lequel l'amplitude du premier signal (341) est adaptée à une valeur de tension prédéfinie en utilisant un circuit d'adaptation de tension.

4. Module lumineux selon une des revendication 2 ou 3 dans lequel ledit premier signal (341) est filtré par un filtre passe-bas (344) afin de générer ledit signal de contrôle (342).

5. Module lumineux selon la revendication précédente, **caractérisé en ce que** la source lumineuse pixellisée comprend une matrice d'éléments électroluminescents monolithique, ou une source lumineuse organique, OLED, segmentée.

6. Module lumineux selon une des revendication 1 à 5, **caractérisé en ce qu'**un dispositif de pilotage du courant électrique indépendant est agencé entre le dispositif de pilotage (100, 200, 300) et la source lumineuse pixellisée (120).

7. Module lumineux selon une des revendications 1 à 6, **caractérisé en ce qu'**au moins une source de courant linéaire est intégrée au substrat de ladite source lumineuse (120).

## Patentansprüche

1. Leuchtmodul für ein Kraftfahrzeug, das eine verpixelte Lichtquelle (120) und eine Steuervorrichtung der Stromversorgung (100, 200, 300) der verpixelten Lichtquelle enthält, wobei die Steuervorrichtung der Stromversorgung (100, 200, 300) enthält:

   - einen Wandler (110, 210), der dazu bestimmt ist, eine elektrische Eingangsspannung in eine elektrische Ladespannung umzuwandeln, die an die verpixelte Lichtquelle zu liefern ist;
   - Regelungseinrichtungen (130, 230) des Wandlers, wobei die Regelungseinrichtungen am Eingang einen für die Stärke des in der verpixelten Lichtquelle fließenden elektrischen Stroms repräsentativen Wert haben,
   - ein Mikrocontrollerelement (140, 240, 340), das eingerichtet ist, ein Steuersignal (142, 242, 342) zu erzeugen, von dem mindestens ein Merkmal von mindestens einem Parameter (122) der verpixelten Lichtquelle (120) abhängt, und um das Steuersignal in die Regelungseinrichtungen einzuspeisen, wobei der mindestens eine Parameter (122) der verpixelten Lichtquelle eine Anzeige der Sperrschichttemperatur der verpixelten Lichtquelle enthält,

wobei das Leuchtmodul **dadurch gekennzeichnet ist, dass** die Regelungseinrichtungen (230) einen Spannungsteiler enthalten, der das Steuersignal vom Mikrocontrollerelement empfängt, damit die Ladespannung eine Funktion der Stärke des in den Regelungseinrichtungen fließenden elektrischen Stroms ist.

2. Leuchtmodul nach Anspruch 1, wobei das Mikrocontrollerelement (340) eingerichtet ist, ein erstes Signal (341) der Art Impulsbreitenmodulation, PWM, zu erzeugen, dessen Tastverhältnis von dem mindestens einen Parameter (122) abhängt und von dem ein Mittelwert dem Steuersignal (342) entspricht.

3. Leuchtmodul nach dem vorhergehenden Anspruch, wobei die Amplitude des ersten Signals (341) unter Verwendung einer Spannungsanpassungsschaltung an einen vordefinierten Spannungswert angepasst wird.

4. Leuchtmodul nach einem der Ansprüche 2 oder 3, wobei das erste Signal (341) von einem Tiefpassfilter (344) gefiltert wird, um das Steuersignal (342) zu erzeugen.

5. Leuchtmodul nach dem vorhergehenden Anspruch, **dadurch gekennzeichnet, dass** die verpixelte Lichtquelle eine monolithische Matrix von Elektrolumineszenzelementen oder eine segmentierte organische Lichtquelle, OLED, enthält.

6. Leuchtmodul nach einem der Ansprüche 1 bis 5, **dadurch gekennzeichnet, dass** eine unabhängige Steuervorrichtung des elektrischen Stroms zwischen der Steuervorrichtung (100, 200, 300) und der verpixelten Lichtquelle (120) eingerichtet ist.

7. Leuchtmodul nach einem der Ansprüche 1 bis 6, **dadurch gekennzeichnet, dass** mindestens eine Linearstromquelle in das Substrat der Lichtquelle (120) integriert ist.

## Claims

1. Light module for a motor vehicle, comprising a pixelated light source (120) and a control device (100, 200, 300) for controlling the electric power supply of said pixelated light source, the control device (100, 200, 300) for controlling the electric power supply comprising:

   - a converter (110, 210) intended to convert an input voltage into a load voltage to be delivered to the pixelated light source;
   - servocontrol means (130, 230) for servocontrolling the converter, the servocontrol means having at input a value representative of the strength of the electric current flowing through the pixelated light source,
   - a microcontroller element (140, 240, 340) arranged to generate a control signal (142, 242, 342), at least one feature of which depends on at least one parameter (122) of the pixelated light source (120), and to inject the control signal into the servocontrol means, the at least one parameter (122) of the pixelated light source comprising an indication of the junction temperature of the pixelated light source,

   the light module being **characterized in that** the servocontrol means (230) comprise a voltage divider receiving the control signal of the microcontroller element so that the load voltage is a function of the strength of the electric current flowing through the servocontrol means.

2. Light module according to Claim 1, wherein the microcontroller element (340) is arranged to generate a first signal (341) of pulse-width modulation, PWM, type, the duty cycle of which depends on said at least one parameter (122) and an average value of which corresponds to said control signal (342).

3. Light module according to the preceding claim, wherein the amplitude of the first signal (341) is matched to a predefined voltage value using a voltage-matching circuit.

4. Light module according to one of Claims 2 and 3, wherein said first signal (341) is filtered by a low-pass filter (344) in order to generate said control signal (342).

5. Light module according to the preceding claim, **characterized in that** the pixelated light source comprises a monolithic array of light-emitting elements, or a segmented organic light source, OLED.

6. Light module according to one of Claims 1 to 5, **characterized in that** an independent device for controlling the electric current is arranged between the control device (100, 200, 300) and the pixelated light source (120).

7. Light module according to one of Claims 1 to 6, **characterized in that** at least one linear current source is integrated into the substrate of said light source (120).

100   110   130

$V_{IN}$

DC / DC

142

140

122

120   $V_{OUT}$

**Fig. 1**

200   210   230

$V_{IN}$

DC / DC

R1

I_ctrl_vout

$V_{FB}$   R2   242

240

122

120   $V_{OUT}$

**Fig. 2**

300

122   341   344   342

340   $V_{ctrl}$

R4   C   R3

**Fig. 3**

**EP 3 592 113 B1**

## RÉFÉRENCES CITÉES DANS LA DESCRIPTION

### Documents brevets cités dans la description

- US 2016143101 A1
- US 2004207532 A1